# EUROPEAN PATENT SPECIFICATION

(11) **EP 0 284 868 B1**
(45) Date of publication and mention of the grant of the patent: **03.05.1995**
(21) Application number: 88104019.0
(22) Date of filing: 14.03.1988
(51) Int. Cl.: G03F 7/004

(54) **Photoresist compositions**
Photolackzusammensetzung
Composition photoréserve

(30) Priority: 30.03.1987 US 31826
(43) Date of publication of application: 05.10.1988
(73) Proprietor: MicroSi, Inc. (a Delaware corporation), Phoenix Arizona 85044 (US)
(72) Inventor: Crivello, James Vincent, Clifton Park New York 12065 (US); O'Brien, Michael Joseph, Albany New York 12203 (US); Lee, Julia Lam, Schenectady New York 12309 (US)
(74) Representative: Green, Mark Charles

(56) References cited:
- EP-A- 0 146 411
- DE-A- 2 306 248
- US-A- 4 708 925
- RESEARCH DISCLOSURE, no. 273, January 1985, page 24, New York, US; "Aqueous-base developable positive resist compositions"
- JOURNAL OF IMAGING TECHNOLOGY, vol. 11, no. 4, August 1985, pages 146-157,Society of Photographic Scientists and Engineers, Springfield, Virginia, US; S.P. PAPPAS: "Photogeneration of acid: Part 6 - A review of basic principles forresist imaging applications"

## Description

The present invention relates to photoresist compositions using an aryl onium salt in combination with a phenol novolak resin and an organic polymer having chemically combined acid labile groups.

Prior to the present invention, as shown by Smith et al., U.S. Patent 3,779,778 for PHOTOSOLUBILIZABLE COMPOSITIONS AND ELEMENTS, photoresists were made by blending together a water-insoluble compound containing one or more acid-degradable groups such as bis-2-tetrahydropyranol ether of 4,4'-isopropylidenediphenol and a binder, for example, a cresol formaldehyde resin. A photolizable organic halogen-containing compound, such as a halomethyl-S-triazene is used as a source of hydrohalic acid when photolized. Smith et al.'s photosolubilizable compositions have been found useful as printing plate compositions. Further, these photosensitive materials require sufficient water to effect hydrolysis of the hydrolizable linkages in the dissolution inhibitor. Therefore, proper atmospheric conditions must be maintained to use these materials in various applications including microelectronic applications.

Additional printing plate compositions are shown by Newman, European Patent Application 146411, filed 12/19/84 for PHOTOSOLUBILIZABLE COMPOSITIONS. Newman's photoresists utilize an onium salt in combination with an alkali-soluble phenolic resin. The Newman photoresist is solvent resistant prior to irradiation and soluble in aqueous alkali solvent when imaged. However, Newman teaches that his photosolubilizable compositions can be converted to a negative photoresist by initially exposing the composition to actinic radiation, followed by a post-bake. The irradiated photoresist which has been post-baked is rendered insoluble to alkali. A second overall exposure of the photoresist to actinic radiation, following image-wise exposure and post-baking, can result in the production of a negative image of the mask when development of the photosolubilized composition is effected in aqueous base.

An additional photoresist composition is shown by Ito et al., U.S. Patent No. 4,491,628, which utilizes a polymer having recurrent labile pendent groups, such as tertiary butylester, or tertiary butyl carbonate groups along a polystyrene, or poly-α-methyl styrene backbone. An aryl onium salt, which can be a diaryl iodonium or triaryl sulfonium salt is used as the deblocking acid source. Ito et al.'s compositions, however, must also be post-baked after irradiation to effect the deblocking of the acid labile group from the backbone of the polymer. The use of Ito et al.'s compositions as positive or negative photoresist, however, has been somewhat restricted. Because these acid labile substituted polymers are not commercially available, these photoresists are economically unattractive.

It would be desirable, therefore, to provide a photoresist composition having ample radiation sensitivity as a result of the use of a dissolution inhibitor which is capable of providing sufficient chemical amplification independent of moisture sensitivity. It also would be desirable to provide a photoresist composition which utilizes a major amount of a commercially available material as a binder which can be subjected to irradiation and post-baking without cross-linking of the binder.

The present invention is based on our discovery that valuable positive photoresist compositions can be made which can be readily photosolubilized and can be readily used under ambient conditions. These photoresist compositions can be made by combining an effective amount of an aryl onium salt with a base-soluble phenol novolak resin having a molecular weight in the range of about 200-20,000 and used in further combination with a dissolution inhibitor in the form of an organic polymer or copolymer having acid labile groups such as t-butyl ether or t-butyl ester along the polymer backbone.

Surprisingly, the photoresist composition can tolerate at least a major amount of the phenol novolac resin in combination with the dissolution inhibitor, and can be post-baked after actinic irradiation to deblock the acid labile groups from the polymer backbone, while remaining completely soluble in the aqueous base. This result is contrary to the teaching of Newman which maintains that post-baking a novolac resin in the presence of an arylonium salt after irradiation results in the crosslinking of the resin and its conversion to a negative photoresist. It has further been found that other acid labile groups can be used to chemically amplify arylonium salt acidolysis after irradiation, such as shown by Frechet et al Journal of Imaging Science, Vol. 30, II (March/April 1986) 59.

There is provided by the present invention a radiation sensitive composition comprising by weight
(a) 100 parts of organic solvent,
(b) 5-85 parts of solids comprising, by weight,
   (1) 100 parts of phenol novolak resin having a M.W. in the range of 200 to 20,000,
   (2) 5 to 100 parts of organic polymer having a M.W. of greater than 1000 and having chemically combined acid labile groups selected from
      (i) organic polymers having t-butylester, t-butylether or aryl t-butyl carbonate groups,
      (ii) aromatic polymers containing pendant carbonates or trimethylsilylether groups,
      (iii) polyacrylates having benzylester groups,
      (iv) polycarbonates prepared by polycondensation of activated carbonates of tertiary or allylic diols with bifunctional phenols or diols,
         which provide ample radiation sensitivity as a result of chemical amolification of aryl onium salt acidolysis along or within the organic polymer backbone, which organic polymer is initially base insoluble and rendered base soluble when exposed to electromagnetic or particle radiation in the presence of an amount by weight of an arylonium salt sufficient to provide the deblocking of the chemically combined acid labile groups along or within the organic polymer backbone as a result of acidic and thermolytic cleavage, and
   (3) an effective amount of arylonium salt.

The organic polymer is preferably a polystyrene, poly-α-methylstyrene, polymethacrylate or polyacrylate.

The organic polymer may also be a copolymer of t-butoxystyrene and methylmethacrylate. The organic polymer may also preferably be poly-4-t-butylvinylbenzoate.

The aryl onium salt may be a diaryliodonium trifluoromethane sulfonate, e.g. 4-methoxyphenylphenyliodonium trifluoromethane sulfonate. The aryl onium salt may also be preferably a triarylsulfonium salt, e.g. 4-thiophenoxyphenyldiphenyl-sulfonium hexafluoroantimonate.

The present invention also relates to a method for making a patterned resist substrate composite which comprises
(1) treating a substrate with the resist composition according to the present invention to produce a resist-substrate composite,
(2) baking the resist-substrate composite to a temperature in the range of from about 35°C to 180°C,
(3) irradiating the applied resist in a patterned manner,
(4) heating the irradiated resist to a temperature in the range of from about 35°C to 185°C, and
(5) developing the irradiated resist to produce a patterned resist substrate composite.

The present invention further relates to a composite made in accordance with the method of the above Claim, particularly a composite wherein the substrate is a silicon wafer or is a copper-clad laminate.

Some of the arylonium salts which can be utilized in the practice of the present invention are, for example, diaryliodonium salts such as

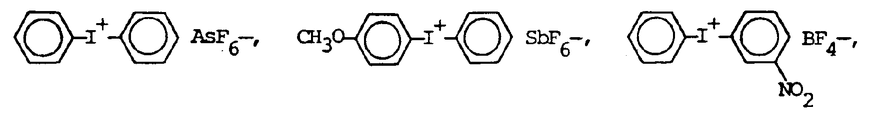

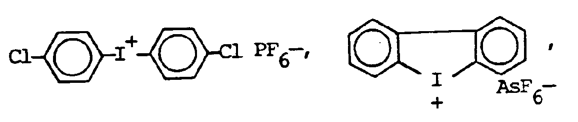

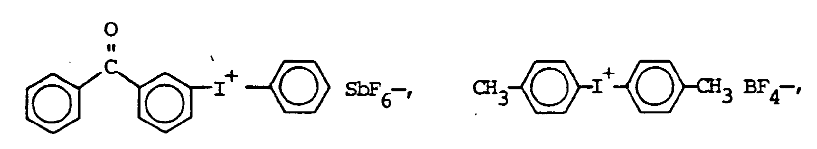

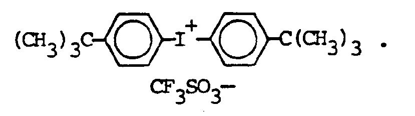

Aryl sulfonium salts such as

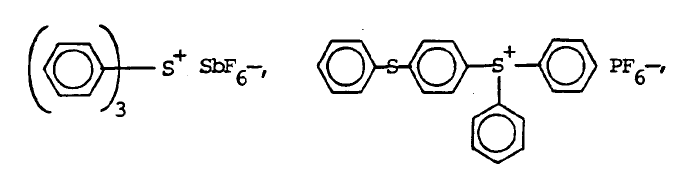

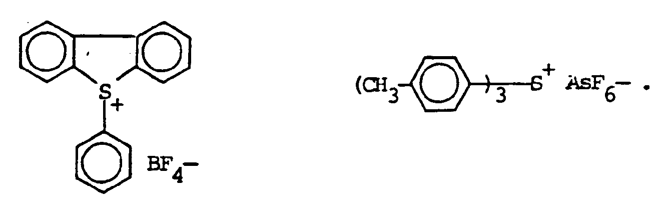

Additional arylonium salts or cationic photoinitiators which can be utilized in the practice of the present invention are, for example,

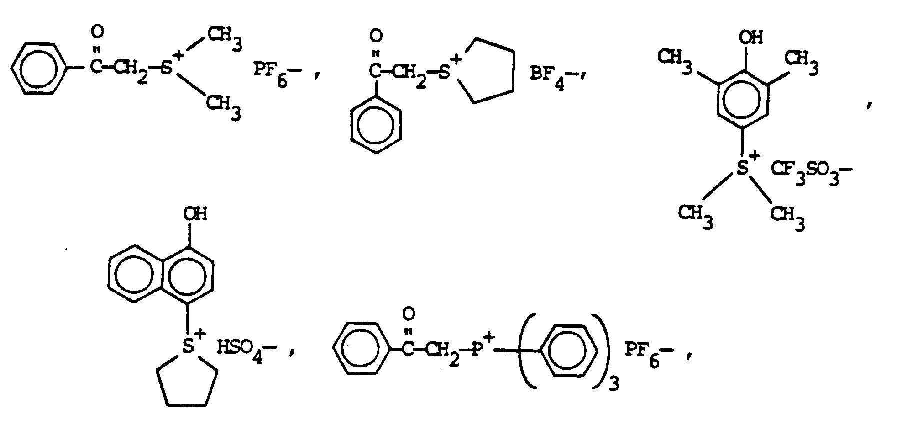

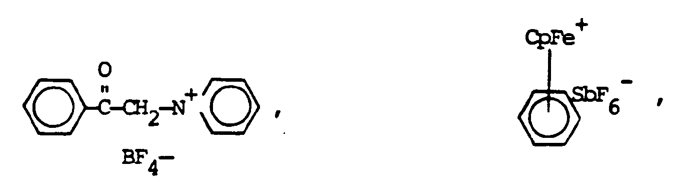

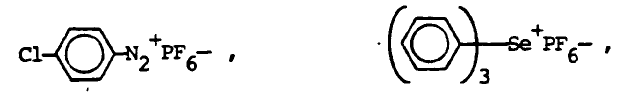

An effective amount of aryl onium salt is from 0.5% to 20% by weight of aryl onium salt based on the total weight of the photoresist composition of the present invention.

Some of the organic polymers having acid labile groups which can be used in the photoresist composition of the present invention, are poly-4-t-butylvinylbenzoate, poly-t-butoxycarbonyloxystyrene or corresponding α-methylstyrene of Ito et al., U.S. Patent 4,491,628 and poly-t-butoxystyrenes and poly-t-butoxy-α-methylstyrenes of Crivello et al., U.S. Patent 4,603,101, incorporated herein by reference. In addition, there are included polyacrylates having t-butylester or benzylester groups, or copolymers where the acid labile group can be pendant to the main chain or within the main chain. Additional aromatic polymers containing pendant carbonates such as t-butoxycarbonyloxy groups and trimethylsilylether groups also can be used.

Additional examples or organic polymer which can be used in the photoresist compositions of the present invention are the previously described reactive polycarbonates, of Frechet et al..

Phenol novolak resins which can be used in the practice of the present invention include those resins prepared from phenol and substituted phenols or bisphenols by reaction with formaldehyde, a formaldehyde derivative or another aldehyde or ketone. Usually, condensation of the aldehyde and phenol are effected under acidic conditions. In addition to phenol novolak resins, there can be utilized cresol novolak resins and chlorophenol novolak resins, etc.

Organic solvents which can be used in the practice of the present invention to make the resist composition are, for example, 1,2-dimethoxyethane, di(2-methoxyethyl)ether, 1-methoxy-2-propylacetate, chlorobenzene, 1,1,2,2-tetrachloroethane, 1-methoxy-2-ethylacetate, dioxane, methylisobutylketone, cyclohexanone, n-butanol, ethyleneglycol, propyleneglycol, amylacetate, and butylacetate.

It has been further found that the afore-described onium salts can be used in combination with various photosensitizers to enhance the absorption of a given wave length of light or sensitize the onium salt to a region of a spectrum where it does not absorb. Typical sensitizers which can be used in combination with the afore-described initiators, or mixtures thereof, are, for example, benzophenone, 2-chlorothioxanthone, anthrone, 9-ethoxyanthrazene, pyrene, perylene, phenothiazene, benzil, acridine orange, benzoflavin, thioflavin-T, anthraquinone, 9,10-diphenylanthracene, 9-fluorenone, and coronene.

In the practice of the invention, the photoresist composition is made by combining the novolak, the organic polymer, aryl onium salt and organic solvent. Development of the resist after imagewise exposure to UV or visible light consists of a brief heating of the resist followed by immersion or spraying of the resist with an aqueous basic solution to dissolve the exposed polymer and the novolak resin.

Some other resist applications contemplated for the resist compositions of the present invention are, for example, manufacture of circuit boards, integrated circuits, multilayer resist structures, e.g. in combination with polymethylmethacrylate, and the like. There also can be used in the resist compositions of the present invention, flow control agents, surface activation agents, antireflective dyes, and wetting agents.

In order that those skilled in the art will be better able to practice the present invention, the following examples are given by way of illustration and not by way of limitation. All parts are by weight.

### EXAMPLE 1

There was stirred until homogeneous, 0.5 gram of poly-t-butoxy-α-methylstyrene having molecular weight of 186,500 g/mol, 0.5 gram of o-cresol novolak resin (Ciba-Gigy hardener H.T. 9490), 0.05 gram of 4-methoxyphenyl, phenyliodonium trifluormethanesulfonate, and 7 ml of 1-methoxy-2-propylacetate. The mixture was then spun onto silicon wafers which had been previously dried and treated with hexamethyldisilazane as an adhesion promoter. The coated wafers were dried for 30 minutes in a forced air oven at 90°C. The wafers were then subjected to image-wise exposure using a Suss MA56 contact/proximity printer operated in a contact mode using UV light of wavelength 254 nm. The output of the lamp was approximately 5.7 mW/cm². An optimum exposure time of from 0.2 seconds to one second was employed. After exposure, the wafers were transferred to a forced air oven and baked at 110-120°C for 30 seconds to one minute. They were then developed by immersing them for one minute in an aqueous sodium hydroxide solution (developer 351 supplied by the KTI Corporation). There was obtained clear images having a resolution of about 1.5 microns.

### EXAMPLE 2

There was spin coated onto silicon wafers, a photoresist solution composed of a mixture of 0.5 grams, ortho-cresol novolak resin (Ciba-Gigy H.T. 9490), 0.5 gram of poly-α-methylbenzylmethacrylate, 0.1 gram of 4-methoxyphenyl phenyliodonium trifluoromethanesulfonate and 7 ml of diglyme. The wafers were then baked and image-wise exposed in accordance with the procedure of Example 1. Cleared features were obtained down to 1.5 microns in size.

### EXAMPLE 3

A mixture of 2.00 gram (11.3 mmol) of 4-t-butoxystyrene, 1.14 gram (11.3 mmol) of methylmethacrylate, and 112 mg (0.68 mmol) of azobisisobutyronitrile was heated under a nitrogen atmosphere at 70°C under sealed conditions for about 12 hours. The resulting solution was allowed to cool and dichloromethane was added to dissolve the product. The solution was then added to methanol resulting in the precipitation of a soft polymeric material. The precipitate was collected by suction filtration, washed three times with methanol and then with water. The resulting product hardened and it was broken into small pieces and dried in a vacuum oven. There was obtained 2.3 grams or a 73% conversion of product having an Mₙ of 18,000, and a T_{g} of 95°C. Based on method of preparation and proton nmr analysis, the product was a 53:47 copolymer of t-butoxystyrene units and methylmethacrylate units.

A photoresist formulation was made by combining 600 mg of Hoechst Alnovol PN430 phenol formaldehyde resin, 550 mg of the above t-butoxystyrene methylmethacrylate copolymer, 70 mg of 4-thiophenoxyphenyldiphenylsulfonium hexafluoroantimonate and 5 ml of 1-methoxy-2-propylacetate. The various ingredients were mixed and the resulting solution was filtered. The solution was then spun onto silicon wafers which had previously been treated with hexamethyldisilazane. The wafers were then baked for 25 minutes in a forced air oven at 85°C. Imagewise exposure was done at 320 nm using a Suss MA56 contact/proximity printer operated in the proximity mode with a lamp intensity of approximately 5.7 milliwatts/cm². Imagewise exposure of 5-7 seconds followed by a postexposure hot plate bake of 10 seconds at 110°C, and then development for 2-3 minutes with Ultramac MF-62 Developer of MacDermid Microelectronic Chemicals resulted in clear positive images of the mask.

Although the above examples are directed to only a few of the very many variables of the components of the photoresist compositions of the present invention and method for making, it should be understood that the present invention is directed to a much broader variety of photoresist compositions and conditions for their production as shown in the description preceding these examples.

## Claims

1. A radiation sensitive composition comprising by weight
(a) 100 parts of organic solvent,
(b) 5-85 parts of solids comprising, by weight,
(1) 100 parts of phenol novolak resin having a M.W. in the range of 200 to 20,000,
(2) 5 to 100 parts of organic polymer having a M.W. of greater than 1000 and having chemically combined acid labile groups selected from
(i) organic polymers having t-butylester, t-butylether or aryl t-butyl carbonate groups,
(ii) aromatic polymers containing pendant carbonates or trimethylsilylether groups,
(iii) polyacrylates having benzylester groups,
(iv) polycarbonates prepared by polycondensation of activated carbonates of tertiary or allylic diols with bifunctional phenols or diols,
which provide ample radiation sensitivity as a result of chemical amolification of aryl onium salt acidolysis along or within the organic polymer backbone, which organic polymer is initially base insoluble and rendered base soluble when exposed to electromagnetic or particle radiation in the presence of an amount by weight of an arylonium salt sufficient to provide the deblocking of the chemically combined acid labile groups along or within the organic polymer backbone as a result of acidic and thermolytic cleavage, and
(3) an effective amount of arylonium salt.

2. A composition in accordance with Claim 1, where the organic polymer is a polystyrene, poly-α-methylstyrene, polymethacrylate or polyacrylate.

3. A composition in accordance with Claim 1, where the organic polymer is a copolymer of t-butoxystyrene and methylmethacrylate.

4. A composition in accordance with Claim 1, where the organic polymer is poly-4-t-butylvinylbenzoate.

5. A composition in accordance with Claim 1, where the aryl onium salt is a diaryliodonium trifluoromethane sulfonate.

6. A composition in accordance with Claim 1, where the aryl onium salt is a triarylsulfonium salt.

7. A composition in accordance with Claim 5, where the diaryliodonium salt is 4-methoxyphenyl-phenyliodonium trifluoromethane sulfonate.

8. A composition in accordance with Claim 6, where the triarylsulfonium salt is 4-thiophenoxyphenyldiphenylsulfonium hexafluoroantimonate.

9. A method for making a patterned resist substrate composite which comprises
(1) treating a substrate with the resist composition according to Claim 1 to produce a resist-substrate composite,
(2) baking the resist-substrate composite to a temperature in the range of from about 35°C to 180°C,
(3) irradiating the applied resist in a patterned manner,
(4) heating the irradiated resist to a temperature in the range of from about 35°C to 185°C, and
(5) developing the irradiated resist to produce a patterned resist substrate composite.

10. A composite made in accordance with the method of Claim 9.

11. A composite in accordance with Claim 10, where the substrate is a silicon wafer.

12. A composite in accordance with Claim 10, where the substrate is a copper-clad laminate.

## Patentansprüche

1. Strahlungsempfindliche Zusammensetzung, bestehend aus in Gewicht
(a) 100 Teilen eines organischen Lösungmittels,
(b) 5 - 85 Teilen Feststoffe, bestehend in Gewicht aus
(1) 100 Teilen Phenol-Novolakharz mit einem Molekular-gewicht in dem Bereich von 200 bis 20.000,
(2) 5 bis 100 Teilen eines organischen Polymers mit einem Molekulargewicht größer als 1000 und mit chemisch vereinigten säurelabilen Gruppen, ausgewählt von
(i) organischen Polymeren mit t-Butylester, t-Butylether oder Aryl-t-butyl-carbonatgruppen,
(ii) aromatischen Polymeren, die schwebende Carbonate oder Trimethylsilylethergruppen enthalten,
(iii) Polyacrylaten mit Benzylestergruppen,
(iv) Polycarbonaten, hergestellt durch eine Polykondensation von aktivierten Carbonaten der tertiären oder Allyldiole mit bifunktionalen Phenolen oder Diolen,
welche eine reichliche Strahlungsempfindlichkeit als ein Ergebnis der chemischen Amolifikation einer Aryloniumsalz-Säurehydrolyse zusammen mit oder innerhalb des organischen Polymerrückgrates ergeben, wobei das organische Polymer anfänglich baseunlöslich ist und baselösbar wird, wenn es einer elektromagnetischen oder einer Partikelbestrahlung in der Gegenwart einer Gewichtsmenge eines Aryloniumsalzes ausgesetzt wird, die ausreicht, um das Entblocken der chemisch vereinigten säurelabilen Gruppen zusammen mit oder innerhalb des organischen Polymerrückgrates als ein Ergebnis der sauren und thermolytischen Spaltung zu erreichen, und
(3) einer wirksamen Menge des Aryloniumsalzes.

2. Zusammensetzung nach Anspruch 1, bei welcher das organische Polymer Polystyrol, Poly-α-methylstyrol, Polymethacrylat oder Polyacrylat ist.

3. Zusammensetzung nach Anspruch 1, bei welcher das organische Polymer ein Copolymer von t-Butoxystyrol und Methylmethacrylat ist.

4. Zusammensetzung nach Anspruch 1, bei welcher das organische Polymer Poly-4-t-Butylvinylbenzoat ist.

5. Zusammensetzung nach Anspruch 1, bei welcher das Aryloniumsalz ein Diaryliodonium-trifluormethansulfonat ist.

6. Zusammensetzung nach Anspruch 1, bei welcher das Aryloniumsalz ein Triarylsulfoniumsalz ist.

7. Zusammensetzung nach Anspruch 5, bei welcher das Diaryliodoniumsalz 4-Methoxyphenyl-phenyliodonium-trifluormethansulfonat ist.

8. Zusammensetzung nach Anspruch 6, bei welcher das Triarylsulfoniumsalz 4-Thiophenoxyphenyldiphenylsulfoniumhexafluorantimonat ist.

9. Verfahren zum Herstellen eines gemusterten Resistsubstratkomposits, bestehend aus
(1) der Behandlung eines Substrats mit einer Resistzusammensetzung nach Anspruch 1 zur Herstellung eines Resistsubstratkomposits,
(2) einem Brennen des Resistsubstratkomposits auf eine Temperatur in dem Bereich von etwa 35°C bis 180°C,
(3) einer Bestrahlung des angewendeten Resists in einer Musteranordnung,
(4) einem Erwärmen des bestrahlten Resists auf eine Temperatur in dem Bereich von etwa 35°C bis 185°C, und
(5) einem Entwickeln des bestrahlten Resists zur Erzeugung eines bemusterten Resistsubstratkomposits.

10. Komposit, hergestellt gemäß dem Verfahren nach Anspruch 9.

11. Komposit nach Anspruch 10, bei welchem das Substrat ein Siliziumwafer ist.

12. Komposit nach Anspruch 10, bei welchem das Substrat ein kupferplattiertes Laminat ist.

## Revendications

1. Composition sensible à un rayonnement, comprenant, en poids
(a) 100 parties de solvant organique,
(b) 5-85 parties de matières solides comprenant, en poids,
(1) 100 parties de résine novolaque phénolique ayant une masse moléculaire dans la gamme de 200 à 20 000,
(2) 5 à 100 parties de polymère organique ayant une masse moléculaire supérieure à 1 000 et possédant des groupes labiles aux acides chimiquement combinés, choisi parmi
(i) les polymères organiques comportant des groupes ester t-butylique, éther de t-butyle ou carbonate d'aryl-t-butyle,
(ii) les polymères aromatiques contenant des groupes pendants carbonate ou triméthylsilyléther,
(iii) les polyacrylates comportant des groupes ester benzylique,
(iv) les polycarbonates préparés par polycondensation de carbonates activés de diols tertiaires ou allyliques avec des phénols bifonctionnels ou des diols,
qui procurent une sensibilité aux rayonnements de grande amplitude du fait de chimique de l'acidolyse du sel d'aryl-onium le long ou au sein de la chaîne principale du polymère organique, ce polymère organique étant initialement insoluble dans les bases et rendu soluble dans les bases lorsqu'il est exposé à un rayonnement électro-magnétique ou particulaire en présence d'une quantité en poids d'un sel d'aryl-onium suffisante pour permettre le déblocage des groupes labiles aux acides chimiquement combinés le long ou au sein de la chaîne principale du polymère organique sous l'action du clivage acide et thermolytique, et
(3) une quantité efficace d'un sel d'aryl-onium.

2. Composition selon la revendication 1, dans laquelle le polymère organique est un polystyrène, un poly(α-méthylstyrène), un polyméthacrylate ou un polyacrylate.

3. Composition selon la revendication 1, dans laquelle le polymère organique est un copolymère de t-butoxystyrène et de méthacrylate de méthyle.

4. Composition selon la revendication 1, dans laquelle le polymère organique est le poly(benzoate de 4-t-butylvinyle).

5. Composition selon la revendication 1, dans laquelle le sel d'aryl-onium est un trifluorométhane-sulfonate de diaryliodonium.

6. Composition selon la revendication 1, dans laquelle le sel d'aryl-onium est un sel de triarylsulfonium.

7. Composition selon la revendication 5, dans laquelle le sel de diaryliodonium est le trifluorométhane-sulfonate de 4-méthoxyphénylphényliodonium.

8. Composition selon la revendication 6, dans laquelle le sel de triarylsulfonium est l'hexafluoroantimonate de 4-thiophénoxyphényldiphénylsulfonium.

9. Procédé de fabrication d'un composite photoréserve-substrat à motifs, qui comprend
(1) le traitement d'un substrat avec la composition de photoréserve selon la revendication 1, pour produire un composite photoréserve-substrat,
(2) la cuisson du composite photoréserve-substrat à une température dans la gamme d'environ 35°C à 180°C,
(3) l'irradiation de la photoréserve appliquée selon un motif,
(4) le chauffage de la photoréserve irradiée à une température dans la gamme d'environ 35°C à 185°C, et
(5) le développement de la photoréserve irradiée pour produire un composite photoréserve-substrat à motifs.

10. Composite préparé selon le procédé de la revendication 9.

11. Composite selon la revendication 10, dans lequel le substrat est une tranche de silicium.

12. Composite selon la revendication 10, dans lequel le substrat est un stratifié plaqué de cuivre.
